# EUROPEAN PATENT SPECIFICATION

(11) **EP 2 279 377 B1**
(45) Date of publication and mention of the grant of the patent: **04.03.2015**
(21) Application number: 09754094.2
(22) Date of filing: 26.05.2009
(51) Int. Cl.: F21K 99/00, F21V 31/00, F21V 29/56, F21V 19/04, F21V 23/06, F21Y 101/02

(54) **LED DEVICE AND ARRANGEMENT**
LED-VORRICHTUNG UND ANORDNUNG
DISPOSITIF À DEL ET AGENCEMENT

(30) Priority: 29.05.2008 GB 0809650
(43) Date of publication of application: 02.02.2011
(73) Proprietor: Integration Technology Limited, Oxfordshire OX25 5HA (GB)
(72) Inventor: SMITH, Jason, Oxfordshire OX25 5HA (GB)
(74) Representative: Bailey, Richard Alan
(86) International application number: PCT/GB2009/001317
(87) International publication number: WO 2009/144449

(56) References cited:
- WO-A1-02/097884
- WO-A2-2007/025525
- AU-A4- 2005 100 101
- DE-A1- 10 251 955
- DE-U1- 20 317 373
- DE-U1-202008 009 910
- US-A1- 2005 207 165
- US-A1- 2006 181 878

## Description

This invention relates to an LED device, and to an arrangement in which a plurality of individual LED devices are used in an array to form a lamp.

LEDs are in increasingly common usage in applications in which a light source is required. One such application is in the curing of inks and the like. In this application, a number of LEDs are arranged in an array, the LEDs being controllable, individually, to permit irradiation of an entire irradiable area (by operation of all of the LEDs) or irradiation of just selected regions of the entire area (by operation of just some of the LEDs). The LEDs used in the light source are of the type designed to emit light in the UV wavelengths. UV LEDs typically produce significant heat levels, and require cooling, in use.

One known LED arrangement for use in this type of application comprises an array of individually controllable UV LEDs, each of which is bonded to a common heat sink, for example of water cooled or air cooled form. The LEDs used in this type of application are expensive, and are often fairly unreliable, sometimes having a life span of as low of 500 hours. The applications in which the LEDs are used require all of the LEDs of the array to be in working order. If just one of the LEDs has failed, then the entire array is rendered unusable and must be replaced. Obviously, replacement of an entire array is inefficient if only one or very few of the LEDs thereof have failed. Replacement of individual LEDs of an array is a complex, time consuming operation as the LEDs need to be removed from the heat sink and, in addition, need removal from the associated control circuit.

US2006/181878 describes an LED device including a heat sink carried by a circuit board thereof. DE20317373 and AU20057100101 both describe LED devices mounted upon circuit boards and having heat sinks associated therewith

It is an object of the invention to provide an LED arrangement in which the disadvantages set out hereinbefore are overcome or of reduced effect.

According to the present invention there is provided an LED arrangement comprising a manifold having a plurality of openings formed therein, and characterised by a plurality of LED devices, each LED device comprising an LED mounted upon a circuit board, an electrical connector carried by the circuit board, and a heat sink carried by the circuit board and arranged to conduct heat away from the LED, the heat sink being provided with a retaining recess within which a seal device is located to permit sealing of the heat sink to the manifold, the heat sink of each LED device extending through a respective one of the openings, and the electrical connectors of the LED devices being releasably connected to a control circuit mounted upon or associated with the manifold.

The LED may comprise a miniature array of LED's.

Preferably, the LED is arranged to emit light in the UV wavelengths.

The heat sink is preferably of tapering form, for example of generally conical form. The heat sink may be of, for example aluminium construction but it will be appreciated that a range of other materials of good thermal conductivity, for example, copper, could be used.

The heat sink may be of hollow form.

The sealing device may comprise an O-ring. The manifold may be arranged to be supplied with water or another liquid coolant which can flow over and around the heat sink to assist in cooling.

The manifold is preferably designed to accommodate the heat sinks of a plurality of such LED devices.

It will be appreciated that, with such an arrangement, if one of the LED devices fails, that LED device can be removed from the manifold and replaced. Replacement of the LED device is a relatively simple process. The remaining LED devices can be left in position. Consequently, there is no need to replace all of the LED devices, including those which are still operational, thus efficiency savings can be made.

A light collector device may be associated with the LED device.

The openings formed in the manifold are conveniently shaped to seal with the seal devices, for example in the form of O-rings, associated with the LED devices.

The invention will further be described, by way of example, with reference to the accompanying drawings, in which:
Figure 1 is a perspective view of an LED device in accordance with one embodiment of the invention;
Figure 2 is a perspective view illustrating an LED arrangement incorporating a plurality of LED devices of the type illustrated in Figure 1;
Figure 3 is another view of the LED arrangement, with parts omitted for clarity; and
Figures 4 to 6 illustrate some alternative embodiments.

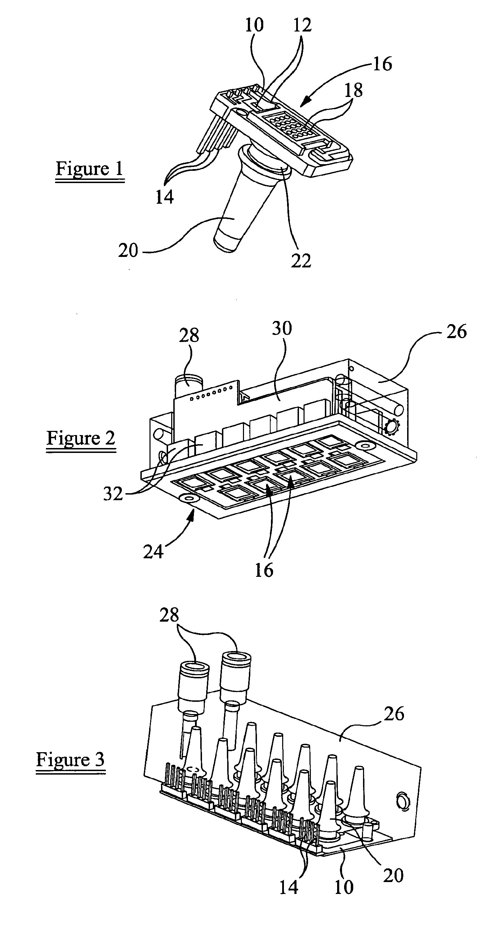

Referring to Figures 1 to 3 of the accompanying drawings, an LED device in accordance with one embodiment of the invention comprises a circuit board 10 which has tracks 12 formed thereon, the tracks 12 being electrically connected to connecting pins 14. At least some of the tracks 12 are further electrically connected to a miniature array 16 of miniature light emitting diodes 18.

Bonded to the rear of the miniature array 16, and carried by the circuit board 10, is a heat sink 20. The heat sink 20 is of generally frustoconical form and defines, at a point close to its connection to the circuit board 10, a recess 22 of annular form. The heat sink 20 is of a material of good thermal conductivity, for example aluminium or copper. As shown in Figures 2 and 3, the LED arrangement 24 comprises a manifold 26 of generally cuboid form. The manifold 26 is designed to have a liquid coolant supplied thereto, and so includes inlet and outlet flow passages 28. A wide range of materials may be used in the construction of the manifold 26 and, in the arrangement illustrated it is of a translucent acrylic material. The material used is preferably of relatively poor thermal conductivity in order to minimise heat transfer from the liquid coolant. Although an acrylic material is used in the arrangement illustrated, it will be appreciated that the invention is not restricted to this material, or even to materials having the same or similar thermal properties thereto.

The manifold 26 is arranged to carry an array of LED devices of the type illustrated in Figure 1. To this end, one face of the manifold 26 is provided with a series of openings of size and position such as to allow the heat sinks 20 of the LED devices to .pass into the interior of the manifold 26. As the manifold 26 is fluid filled, in use, it is desirable to form a seal between each LED device and the manifold 26. A number of types of seal device or sealing techniques may be used to achieve this. In the arrangement illustrated the seal device takes the form of an O-ring (not shown) located in the recess 22 of each heat sink 20, the O-rings bearing against corresponding formations provided in the manifold 26 around each opening thereof to seal the heat sinks 20 to the manifold 26. It will be appreciated, however, that the invention is not restricted in this regard.

Circuit boards 30 carrying at least part of a control circuit for controlling the operation of the LED devices are mounted upon the manifold 26, the circuit boards 30 including connectors 32 arranged to cooperate with the connecting pins 14 of the LED devices.

In use, whilst all of the LED devices are operating correctly, the operation of each LED device is controlled by the control circuit, control signals being transmitted to the LED devices via the connectors 32 and connecting pins 14. It will be appreciated that, depending upon the desired mode of operation, all of the LED devices may be illuminated or, alternatively, only some of the LED devices may be illuminated at any given time. Heat from the junctions of the LED devices is conducted via the heat sinks 20 to the liquid coolant within the manifold 26. The generally frustoconical form of the heat sinks 20 results in a relatively large surface area thereof being available for heat transfer to the liquid coolant, thus assisting in heat transfer.

If it is determined that one of the LED devices has developed a fault, for example the miniature array 16 thereof is no longer operational or is no longer able to emit light at a required intensity, that one of the LED devices is removed from the manifold 26 and replaced with a new LED device. During the removal operation, the connecting pins 14 are disconnected from the associated connector 32 and the heat sink 20 is removed from the manifold 26. The replacement operation requires the heat sink 20 of the replacement LED device to be introduced into the appropriate opening in the manifold 26, the connecting pins 14 to be located in cooperation with the corresponding connector 32, and in the LED device being pushed home so that the O-ring associated with the replacement LED device forms a seal with the manifold 26. The LED arrangement is then, once again, ready for use.

It will be appreciated that, during the removal and replacement operation the opening in the manifold 26 is not sealed and so care needs to be taken to ensure that the manifold 26 is orientated to avoid the escape of liquid coolant.

The arrangement of the invention is advantageous in that, in the event of a failure, only the failed one or ones of the LED devices needs to be replaced, those that are still operational being kept in use. As a result, cost and efficiency saving can be made. Further, replacement can be achieved swiftly as there is no need to de-bond the LED device from a heat sink or to separate and remake a complex electrical connection with the control circuit board.

Although the arrangement described hereinbefore is of a liquid cooled form, it will be appreciated that the invention is also applicable to air or gas cooled arrangements, and appropriate modifications can be made to the arrangement described herein to permit such use without departing from the scope of the invention.

Rather than have the coolant flow over and around the heat sink 20, the heat sink 20 may simply be received within a recess formed in the manifold 26, the manifold 26 having coolant flowing therein. Such an arrangement may require the manifold to be of a material of better thermal conductivity, but does have the benefit that coolant will not be able to escape during replacement of the LED devices.

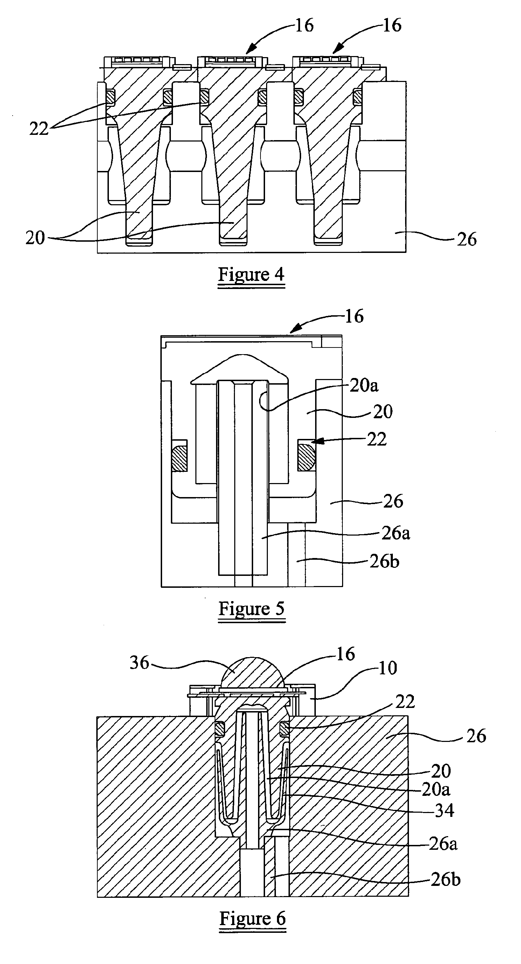

Referring to Figure 4, an LED arrangement similar to that of Figures 1 to 3 is shown, and it will be appreciated that in this arrangement coolant flows to each heat sink 20 in sequence. Although shown as being of generally conical form, the heat sinks 20 could be of other shapes, for example they could be cylindrical. Further, ribs or grooves, for example of straight or helical form, could be provided thereon if desired.

Figures 5 and 6 illustrate alternative designs in which the heat sink 20 is of hollow form, including a recess 20a into which coolant fluid can be directed. As shown in Figure 5, an inlet pipe 26a, which could be a separate component (as shown) or could be integral with the manifold 26 directs coolant into the recess 20a to cool the heat sink 20, the coolant flowing through an annular path between the heat sink 20 and the pipe 26a to an outlet passage 26b. Of course, the fluid flow direction may be reversed if desired. Further, the inlet pipe 26a and outlet passage 26b may be arranged concentrically if desired.

The heat sink 20 is shown, in this embodiment, as being of generally cylindrical form but it will be appreciated that other forms, for example conical forms, are also possible. Further, the recess 20a is shown as being of cylindrical form but could be, for example, conical, and may be provided with ribs or grooves or the like if desired.

In the arrangement of Figure 5 the coolant flows, primarily, within the recess 20a. This need not always be the case and Figure 6 illustrates a modification in which coolant flows both within the recess 20a and around the exterior of the heat sink 20, enhancing cooling thereof This is achieved by the use of a deflector 34 attached to or formed integrally with the inlet pipe 26a and operable to deflect coolant fluid around the exterior of the heat sink 20 after having flowed along the annular passage defined between the heat sink 20 and the inlet pipe 26a.

As with the other embodiments, the internal and external shape of the heat sink 20 may be modified, and ribs, grooves or other formations may be provided if desired. Further, the coolant flow direction may be reversed if desired.

It will be appreciated that in the arrangements of Figures 5 and 6 each heat sink 20 can be provided with its own flow of coolant, thus the formation of temperature gradients across the arrangement can be reduced, all of the LED devices being exposed to substantially the same level of cooling.

In the arrangement of Figure 6 a light collector 36 is provided over the array 16 to reduce internal reflection and so enhance transmission of light from the array. It will be appreciated that similar light collectors could be used in the other described embodiments.

A number of other modifications and alterations may be made to the arrangements described herein without departing from the scope of the invention. For example, many other types of seal arrangement could be used. One possibility is the use of bonded seals, but it will be appreciated that the invention is not restricted in this regard. Further, the direction and manner in which coolant flows through the manifold and/or over the heat sinks may vary from the arrangements outlined hereinbefore, and the heat sinks may be of a wide range of shapes and sizes without departing from the scope of the invention.

## Claims

1. An LED arrangement comprising a manifold (26) having a plurality of openings formed therein, and **characterised by** a plurality of LED devices, each LED device comprising an LED (18) mounted upon a circuit board (10), an electrical connector (14) carried by the circuit board (10), and a heat sink (20) carried by the circuit board (10) and arranged to conduct heat away from the LED (18), the heat sink (20) being provided with a retaining recess (22) within which a seal device is located to permit sealing of the heat sink (20) to the manifold (26), the heat sink (20) of each LED device extending through a respective one of the openings, and the electrical connectors of the LED devices being releasably connected to a control circuit mounted upon or associated with the manifold (26).

2. An arrangement according to Claim 1, wherein the LED (18) comprises a miniature array (16) of LED's (18).

3. An arrangement according to Claim 1 or Claim 2, wherein the LED (18) is arranged to emit light in the UV wavelengths.

4. An arrangement according to any one of the preceding claims, wherein the heat sink (20) Is of tapering form.

5. An arrangement according to Claim 4, wherein the heat sink (20) is of generally conical form.

6. An arrangement according to any of the preceding claims, wherein the heat sink (20) is of hollow form.

7. An arrangement according to any of the preceding claims, wherein the sealing device comprises an O-ring.

8. An arrangement according to any of the preceding claims, further comprising means (26a) for directing a coolant into a hollow interior (20a) of the heat sink (20).

9. An arrangement according to Claim 8, further comprising a deflector (34) for directing coolant around the heat sink (20).

10. An arrangement according to any of the preceding claims, wherein the manifold (26) is arranged to be supplied with water or another liquid coolant which can flow over, around and/or within the heat sink (20) to assist in cooling.

## Patentansprüche

1. LED-Anordnung, umfassend ein Verteilerstück (26) mit einer Vielzahl von darin ausgebildeten Öffnungen und **gekennzeichnet durch** eine Vielzahl von LED-Bauelementen, wobei jedes LED-Bauelement eine auf einer Leiterplatte (10) montierte LED (18), einen **durch** die Leiterplatte (10) getragenen elektrischen Verbinder (14) und eine Wärmesenke (20), die **durch** die Leiterplatte (10) getragen wird und dafür eingerichtet ist, Wärme von der LED (18) fortzuleiten, umfasst, wobei die Wärmesenke (20) mit einer Halteaussparung (22) versehen ist, in welcher ein Dichtelement angeordnet ist, um eine Abdichtung der Wärmesenke (20) zum Verteilerstück (26) zu ermöglichen, wobei sich die Wärmesenke (20) jedes LED-Bauelements **durch** eine jeweilige der Öffnungen erstreckt und die elektrischen Verbinder der LED-Bauelemente lösbar mit einer auf dem Verteilerstück (26) montierten oder ihm zugeordneten Steuerungsschaltung verbunden sind.

2. Anordnung nach Anspruch 1, worin die LED (18) eine Miniaturanordnung (16) von LEDs (18) umfasst.

3. Anordnung nach Anspruch 1 oder Anspruch 2, worin die LED (18) dafür eingerichtet ist, Licht in den UV-Wellenlängen zu emittieren.

4. Anordnung nach einem der vorhergehenden Ansprüche, worin die Wärmesenke (20) eine sich verjüngende Form hat.

5. Anordnung nach Anspruch 4, worin die Wärmesenke (20) im Wesentlichen Kegelform hat.

6. Anordnung nach einem der vorhergehenden Ansprüche, worin die Wärmesenke (20) eine hohle Form hat.

7. Anordnung nach einem der vorhergehenden Ansprüche, worin das Dichtelement einen O-Ring umfasst.

8. Anordnung nach einem der vorhergehenden Ansprüche, ferner Mittel (26a) zum Leiten eines Kühlmittels in ein hohles Inneres (20a) der Wärmesenke (20) umfassend.

9. Anordnung nach Anspruch 8, ferner ein Leitblech (34) zum Leiten von Kühlmittel um die Wärmesenke (20) umfassend.

10. Anordnung nach einem der vorhergehenden Ansprüche, worin das Verteilerstück (26) dafür eingerichtet ist, mit Wasser oder einem anderen flüssigen Kühlmittel versorgt zu werden, das über, um und/oder innerhalb der Wärmesenke (20) fließen kann, um beim Kühlen zu helfen.

## Revendications

1. Agencement à DEL comprenant un distributeur (26) présentant une pluralité d'ouvertures formées dans celui-ci, et **caractérisé par** une pluralité de dispositifs à DEL, chaque dispositif à DEL comprenant une DEL (18) montée sur une carte de circuits imprimés (10), un connecteur électrique (14) porté par la carte de circuits imprimés (10) et un dissipateur thermique (20) porté par la carte de circuits imprimés (10) et agencé pour éloigner par conduction la chaleur de la DEL (18), le dissipateur thermique (20) étant pourvu d'une concavité de retenue (22) à l'intérieur de laquelle est disposé un dispositif de joint visant à étancher le dissipateur thermique (20) vis-à-vis du distributeur (26), le dissipateur thermique (20) de chaque dispositif à DEL passant par une ouverture respective parmi lesdites ouvertures, et les connecteurs électriques des dispositifs à DEL étant raccordés de manière amovible à un circuit de commande monté sur le distributeur (26) ou associé à ce dernier.

2. Agencement selon la revendication 1, dans lequel la DEL (18) comprend un ensemble miniature (16) desdites DEL (18).

3. Agencement selon la revendication 1 ou la revendication 2, dans lequel la DEL (18) est agencée pour émettre de la lumière dans la plage des longueurs d'onde UV.

4. Agencement selon l'une quelconque des revendications précédentes, dans lequel le dissipateur thermique (20) est de forme évasée.

5. Agencement selon la revendication 4, dans lequel le dissipateur thermique (20) est de forme globalement conique.

6. Agencement selon l'une quelconque des revendications précédentes, dans lequel le dissipateur thermique (20) est de forme creuse.

7. Agencement selon l'une quelconque des revendications précédentes, dans lequel le dispositif de joint comprend un joint torique.

8. Agencement selon l'une quelconque des revendications précédentes, comprenant en outre un moyen (26a) destiné à diriger un liquide de refroidissement dans un intérieur creux (20a) du dissipateur thermique (20).

9. Agencement selon la revendication 8, comprenant en outre un déflecteur (34) destiné à diriger le liquide de refroidissement autour du dissipateur thermique (20).

10. Agencement selon l'une quelconque des revendications précédentes, dans lequel le distributeur (26) est agencé pour recevoir de l'eau ou un autre liquide de refroidissement susceptible de s'écouler sur, autour et/ou à l'intérieur du dissipateur thermique (20) pour faciliter le refroidissement.
